# EUROPEAN PATENT APPLICATION

(11) **EP 2 416 376 A2**
(43) Date of publication of application: **08.02.2012**
(21) Application number: 10759019.2
(22) Date of filing: 30.03.2010
(51) Int. Cl.: H01L 31/042, H01L 31/18

(54) **SOLAR PHOTOVOLTAIC POWER GENERATION APPARATUS AND MANUFACTURING METHOD THEREOF**

(30) Priority: 31.03.2009 KR 20090027876; 31.03.2009 KR 20090027877
(71) Applicant: LG Innotek Co., Ltd, Seoul 150-721 (KR)
(72) Inventor: LEE, Dong Keun, Junbg-gu Seoul, 100-714 (KR); JEE, Suk Jae, Junbg-gu Seoul, 100-714 (KR)
(74) Representative: Novagraaf Technologies
(86) International application number: PCT/KR2010/001953
(87) International publication number: WO 2010/114294

(57) **Abstract**

Disclosed are a solar cell apparatus and a method of fabricating the same. The solar cell apparatus includes a substrate; an electrode layer having a first through hole on the substrate; a light absorption layer having a second through hole on the electrode layer; and a window layer having a third through hole overlapped with the second through hole on the light absorption layer. Since the second through hole overlaps with the third through hole, an area of a dead zone, which is a non-active region, is reduced so that the efficiency of the solar cell apparatus is improved.

## Description

### [Technical Field]

The disclosure relates to a solar cell apparatus and a method of fabricating the same.

### [Background Art]

Recently, as energy consumption has been increased, a solar cell capable of converting solar energy into electric energy has been developed.

In particular, a CIGS solar cell, which is a PN hetero junction device having a substrate structure including a glass substrate, a metal back electrode layer, a P type CIGS light absorption layer, a high-resistance buffer layer, and an N type window layer, is extensively used.

Inaddition, in order to fabricate such a solar cell, amechanical patterning process may be performed. At this time, a dead zone, which is not used for power generation, may be formed through the mechanical patterning process, so that the power generation efficiency of the solar cell may be lowered.

### [Disclosure]

### [Technical Problem]

The disclosure provides a solar cell apparatus capable of improving the power generation efficiency.

### [Technical Solution]

A solar cell apparatus according to the embodiment includes a substrate; an electrode layer having a first through hole on the substrate; a light absorption layer having a second through hole on the electrode layer; and a window layer having a third through hole overlapped with the second through hole on the light absorption layer.

A solar cell apparatus according to the embodiment includes a substrate; first and second back electrodes spaced apart from each other on the substrate; a first light absorption part on the first back electrode; a first window on the first light absorption part; a second light absorption part on the second back electrode; a second window on the second light absorption part; and a connection part extending from the first window and making contact with one lateral side of the first light absorption part while being spaced apart from the second light absorption part so as to be connected to the second back electrode, wherein the connection part makes contact with a lateral side and a top surface of the second back electrode.

A method of fabricating a solar cell apparatus according to the embodiment includes forming an electrode layer on a substrate; forming a first through hole by partially removing the electrode layer; forming a light absorption layer on the electrode layer; forming a second through hole adjacent to the first through hole by partially removing the light absorption layer; forming a window layer on the light absorption layer; and forming a third through hole overlapped with the second through hole by partially removing the window layer.

### [Advantageous Effects]

According to the solar cell apparatus of the disclosure, the second through hole overlaps with the third through hole. In addition, the first through hole overlaps with the second through hole or the first through hole is closely adjacent to the second through hole.

The first through hole is used to separate back electrodes from each other, the second through hole is used to electrically connect adjacent cells to each other, and the third through hole is used to separate adjacent windows from each other.

In addition, the first to third through holes are non-active regions where the light may not be converted into the electric energy. The first and second through holes are overlapped with each other or adjacent to each other and the second and third through holes are overlapped with each other. Thus, the solar cell apparatus according to the disclosure can reduce the area of the non-active regions.

The solar cell apparatus according to the disclosure includes a connection part extending from the first window and making contact with the lateral side and top surface of the second back electrode.

Thus, the contact area between the connection part and the second back electrode maybe increased and the short is prevented from occurring between the first window and the second back electrode. The solar cell apparatus according to the disclosure may have low contact resistance.

In addition, a distance between the first and second back electrodes may be increased, so that the short can be prevented from occurring between the first and the second back electrodes.

The solar cell apparatus according to the disclosure may have the improved efficiency and low defective rate.

Further, according to the method of fabricating the solar cell apparatus of the disclosure, the third through hole is formed such that the third through hole can be overlapped with the second through hole. Similarly, the first through hole is overlapped with the second through hole.

Therefore, according to the method of fabricating the solar cell apparatus of the disclosure, it is not necessary to individually pattern the plural layers to separate the cells from each other. That is, the material to form the window layer is filled in the second through hole and the layer exclusively including the material to form the window layer is removed in order to form the third through hole.

Thus, according to the method of fabricating the solar cell apparatus of the disclosure, the second through hole can be formed by removing the layer including the single-type material, so that the third hole can be effectively formed by using a laser.

### [Description of Drawings]

FIG. 1 is a plan view showing a solar cell apparatus according to the embodiment;
FIG. 2 is an enlarged view of an "A" portion shown in FIG. 1;
FIG. 3 is a sectional view taken along line B-B' of FIG. 2;
FIGS. 4 to 8 are sectional views showing the method of fabricating a solar cell apparatus according to the embodiment;
FIG. 9 is a sectional view showing the method of fabricating a solar cell apparatus according to the embodiment;
FIG. 10 is a plan view showing a solar cell apparatus according to another embodiment;
FIG. 11 is an enlarged view of a "C" portion shown in FIG. 10;
FIG. 12 is a sectional view taken along line D-D' of FIG. 11;
FIGS. 13 to 18 are sectional views showing the method of fabricating a solar cell apparatus according to another embodiment; and
FIG. 19 is a sectional view showing the method of fabricating a solar cell apparatus according to another embodiment.

### [Best Mode]

### [Mode for Invention]

In the description of the embodiments, it will be understood that, when a substrate, a film, an electrode, a groove or a layer is referred to as being "on" or "under" another substrate, another film, another electrode, another groove, or another layer, it can be "directly" or "indirectly" over the other substrate, film, electrode, groove, or layer, or one or more intervening layers may also be present. Such a position of the layer has been described with reference to the drawings. The thickness and size of each layer shown in the drawings may be exaggerated, omitted or schematically drawn for the purpose of convenience or clarity. In addition, the size of elements does not utterly reflect an actual size.

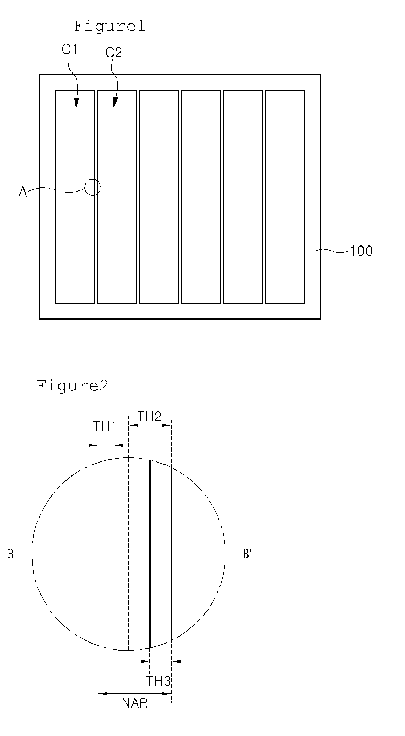

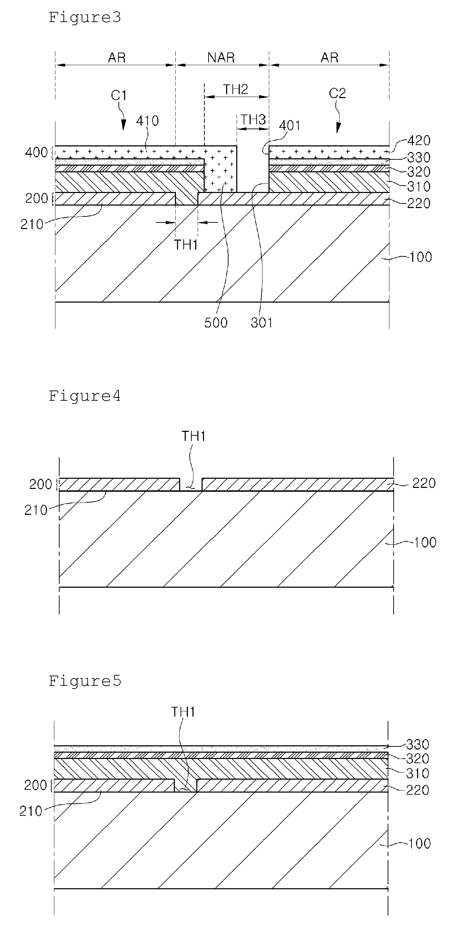

FIG. 1 is a plan view showing a solar cell apparatus according to the embodiment, FIG. 2 is an enlarged view of an "A" portion shown in FIG. 1, and FIG. 3 is a sectional view taken along line B-B' of FIG. 2.

Referring to FIGS. 1 to 3, the solar cell apparatus includes a support substrate 100, a back electrode layer 200, a light absorption layer 310, a buffer layer 320, a high-resistance buffer layer 330, a window layer 400 and a connection part 500.

The support substrate 100 has a plate shape to support the back electrode layer 200, the light absorption layer 310, the window layer 400 and the connection part 500.

The support substrate 100 may include an insulating substance. The support substrate 100 may include a plastic substrate or a metal substrate. In detail, the support substrate 100 may include a soda lime glass substrate. The support substrate 100 may be transparent. The support substrate 100 may be rigid or flexible.

The back electrode layer 200 is aligned on the support substrate 100. The back electrode layer 200 is a conductive layer. For instance, the back electrode layer 200 may include a metal, such as molybdenum.

In addition, the back electrode layer 200 may include at least two layers, which are formed by using the same metal or different metals.

A first through hole TH1 is formed in the back electrode layer 200. The first through hole TH1 is an open region to expose the top surface of the support substrate 100. When viewed from the top, the first through hole TH1 may extend in one direction.

The first through hole TH1 may have a width of about 30µm to about 60µm.

The back electrode layer 200 is divided into a plurality of back electrodes 210, 220... and 200n by the first through hole TH1. That is, the back electrodes 210, 220... and 200n are defined by the first through hole TH1.

The back electrodes 210, 220... and 200n are spaced apart from each other by the first through hole TH1. The back electrodes 210, 220... and 200n are arranged in a stripe pattern. The back electrodes 210, 220... and 200n correspond to the cells, respectively.

In contrast, the back electrodes 210, 220... and 200n can be arranged in the form of a matrix. In this case, the first through hole TH1 may have a lattice shape when viewed from the top.

The light absorption layer 310 is formed on the back electrode layer 200. In addition, the material included in the light absorption layer 310 is filled in the first through hole TH1.

The light absorption layer 310 may include I-III-VI group compound. For instance, the light absorption layer 310 may include the Cu-In-Ga-Se (Cu(In,Ga)Se2; CIGS) crystal structure, the Cu-In-Se crystal structure or the Cu-Ga-Se crystal structure.

The light absorption layer 310 may have the energy bandgap of about leV to about 1.8eV.

The buffer layer 320 is formed on the light absorption layer 310. The buffer layer 320 includes CdS and has the energy bandgap of about 2.2eV to about 2.4eV.

The high-resistance buffer layer 330 is formed on the buffer layer 320. The high-resistance buffer layer 330 includes i-ZnO which is not doped with impurities. The high-resistance buffer layer 330 has the energy bandgap of about 3.1eV to about 3.3eV.

A second through hole TH2 is formed in the light absorption layer 310, the buffer layer 320 and the high-resistance buffer layer 330. That is, the second through hole TH2 is formed through the light absorption layer 310, the buffer layer 320 and the high-resistance buffer layer 330. The second through hole TH2 is an open region to expose the top surface of the back electrode layer 200.

The second through hole TH2 is adjacent to the first through hole TH1. That is, the second through hole TH2 is formed nearby the first through hole TH1. A distance between the first and second through holes TH1 and TH2 is about 1µm to about 100µm.

The second through hole TH2 may have a width of about 100µm to about 200µm.

The back electrodes 210, 220... and 200n may have step difference. In detail, the back electrodes 210, 220... and 200n are partially removed corresponding to the second through hole TH2 such that the step difference can be formed among them.

In other words, the thickness of the back electrode layer 200 may be variable according to the position thereof. For instance, the thickness of the back electrode layer 200 at the region corresponding to the second through hole TH2 may be thinner than the thickness of the back electrode layer 200 at the region besides the second through hole TH2.

The window layer 400 is formed on the high-resistance buffer layer 330. The window layer 400 is a transparent conductive layer. For instance, the window layer 400 may include Al-doped ZnO (AZO).

A third through hole TH3 is formed in the window layer 400. The third through hole TH3 is an open region to expose the top surface of the back electrode layer 200. The third through hole TH3 has a width smaller than a width of the second through hole TH2. For instance, the third through hole TH3 may have a width of about 50µm to about 100µm.

The third through hole TH3 is located corresponding to the second through hole TH2. In detail, the third through hole TH3 overlaps with the second through hole TH2. In other words, the third through hole TH3 may partially or entirely overlap with the second through hole TH2 when viewed from the top.

In addition, a part 401 of an inner side of the third through hole TH3 is aligned on the same plane with a part 301 of an inner side of the second through hole TH2. For instance, one inner side 401 of the third through hole TH3 matches with one inner side 301 of the second through hole TH2.

The window layer 400 is divided into a plurality of windows 410, 420... and 400n by the third through hole TH3. That is, the windows 410, 420... and 400n are defined by the third through hole TH3.

The windows 410, 420... and 400n have shapes corresponding to the shapes of the back electrodes 210, 220... and 200n. In detail, the windows 410, 420... and 400n are arranged in a stripe pattern. In contrast, the windows 410, 420... and 400n can be arranged in the form of a matrix.

The windows 410, 420... and 400n constitute an N type conductive layer to supply electrons to the light absorption layer 310. In addition, the windows 410, 420... and 400n may have the function of an electrode.

A plurality of cells C1, C2...and Cn are defined by the third through hole TH3. In detail, the cells C1, C2...and Cn are defined by the second and third through holes TH2 and TH3. That is, the solar cell apparatus according to the embodiment is divided into the cells C1, C2...and Cn by the second and third through holes TH2 and TH3.

The connection part 500 is positioned in the second through hole TH2. The connection part 500 extends downward from the window layer 400 and directly makes contact with the back electrode layer 200.

Thus, the connection part 500 connects the window with the back electrode included in adjacent cells, respectively. In detail, the connection part 500 connects the window 410 included in the first cell C1 with the back electrode 220 included in the second cell C2 adjacent to the first cell C1.

The connection part 500 is integrally formed with the windows 410, 420... and 400n. That is, the connection part 500 is formed by using a material the same as that of the window layer 400.

The connection part 500 makes contact with one side of the second through hole TH2 and is spaced apart from the other side 301 of the second through hole TH2. For instance, the connection part 500 makes contact with a lateral side of a light absorption part included in the first cell C1 and is spaced apart from a lateral side of a light absorption part included in the second cell C2.

The first to third through holes TH1 to TH3 are dead zones where the light may not be converted into the electric energy. That is, the first to third through holes TH1 to TH3 are non-active regions (NAR).

Since the third through hole TH3 overlaps with the second through hole TH2, the area of the non-active regions can be reduced.

In particular, one inner side of the second through hole TH2 is aligned on the same plane with one inner side of the third through hole TH3. In addition, one inner side of the second through hole TH2 and one inner side of the third through hole TH3 are located at an outer region of the dead zones. That is, the second through hole TH2 and the third through hole TH3 are properly located to minimize the dead zones.

Thus, the solar cell apparatus according to the embodiment can increase the area of the active region where the light is converted into the electric energy, so that the efficiency of the solar cell apparatus can be improved.

FIGS. 4 to 8 are sectional views showing the method of fabricating the solar cell apparatus according to the embodiment. The following description will be made with reference to the above description about the solar cell apparatus according to the embodiment.

Referring to FIG. 4, the back electrode layer 200 is formed on the support substrate 100 and is patterned to form the first through hole TH1. Thus, a plurality of back electrodes 210, 220...and 200n are formed on the support substrate 100. A laser is used to pattern the back electrode layer 200.

The first through hole TH1 exposes the top surface of the support substrate 100 and has a width of about 30µm to about 60µm.

In addition, an additional layer, such as a diffusion barrier, can be interposed between the support substrate 100 and the back electrode layer 200. In this case, the first through hole TH1 exposes the top surface of the additional layer.

Referring to FIG. 5, the light absorption layer 310, the buffer layer 320 and the high-resistance buffer layer 330 are sequentially formed on the back electrode layer 200.

The light absorption layer 310 can be formed through the sputtering process or the evaporation process.

For instance, Cu, In, Ga and Se are simultaneously or individually evaporated to form the CIGS (Cu (In, Ga) Se₂) light absorption layer 310, or the selenization process is performed after forming a metal precursor layer in order to form the light absorption layer 310.

According to the selenizationprocess, the metal precursor layer is formed on the back electrode layer 200 by performing the sputtering process using a Cu target, an In target and a Ga target.

Then, the metal precursor layer is processed through the selenization process, thereby forming the CIGS light absorption layer 310.

In addition, the sputtering process using the Cu target, the In target and the Ga target and the selenization process can be simultaneously performed.

Further, the CIS light absorption layer 310 or the CIG light absorption layer 310 can be formed by performing the sputtering process using the Cu target and the In target or the Cu target and the Ga target and the selenization process.

Then, CdS is deposited on the light absorption layer 310 through the sputtering process, so that the buffer layer 320 is formed.

After that, ZnO is deposited on the buffer layer 320 through the sputtering process, so that the high-resistance buffer layer 330 is formed.

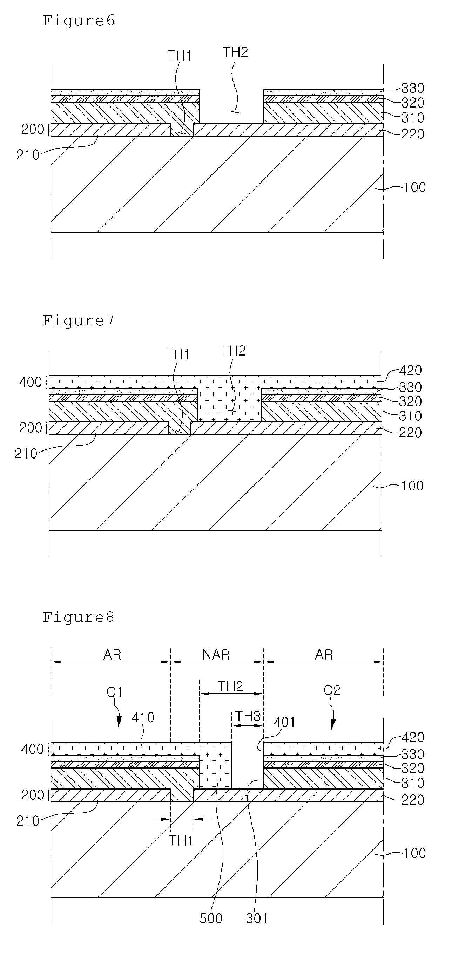

Referring to FIG. 6, the light absorption layer 310, the buffer layer 320 and the high-resistance buffer layer 330 are partially removed to form the second through hole TH2. The second through hole TH2 is formed through the light absorption layer 310, the buffer layer 320 and the high-resistance buffer layer 330.

The second through hole TH2 is adjacent to the first through hole TH1. The second through hole TH2 can be formed by using a mechanical device, such as a tip, or a laser device.

For instance, the light absorption layer 310 can be patterned by a tip having a width of about 40µm to about 180µm. In addition, the second through hole TH2 can be formed by a laser beam having a wavelength of about 200nm to about 600nm.

At this time, the second through hole TH2 may have a width of about 100µm to about 200µm. In addition, the second through hole TH2 may expose a part of the top surface of the back electrode layer 200.

Referring to FIG. 7, the window layer 400 is formed on the high-resistance buffer layer 330. At this time, the material to form the window layer 400 is filled in the second through hole TH2.

In order to form the window layer 400, a transparent conductive material is deposited on the high-resistance buffer layer 330. The second through hole TH2 is fully filled with the transparent conductive material. For instance, the transparent conductive material includes Al-doped ZnO.

Referring to FIG. 8, the window layer 400 is partially removed to form the third through hole TH3. That is, the window layer 400 is patterned to define the windows 410, 420... and 400n and cells C1, C2...and Cn.

While the third through hole TH3 is being formed, the transparent conductive material filled in the second through hole TH2 is partially removed. Thus, the top surface of the back electrode layer 200 is exposed through the third through hole TH3.

In addition, the connection part 500, which extends from the window layer 400 and directly makes contact with the back electrode layer 200, is formed in the second through hole TH2.

One inner side of the third through hole TH3 matches with one inner side of the second through hole TH2.

For instance, the window layer 400 and the transparent conductive material filled in the second through hole TH2 may be partially removed in such a manner that one inner side of the third through hole TH3 matches with one inner side of the second through hole TH2.

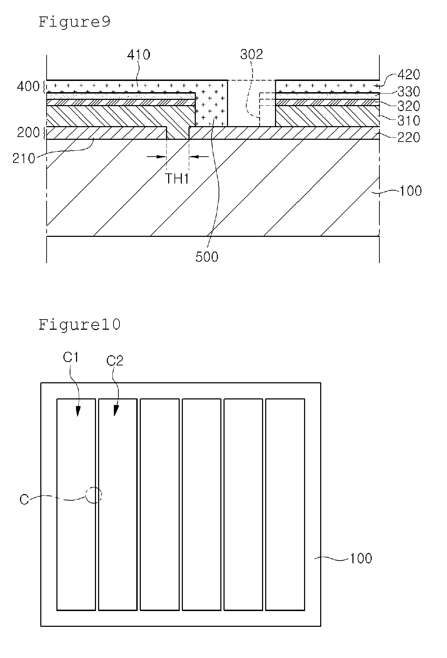

In contrast, as shown in FIG. 9, a part of the window layer 400, the light absorption layer 310, the buffer layer 320 and a part 302 of the high-resistance buffer layer 330 can be removed while the third through hole TH3 is being formed.

The third through hole TH3 is partially or entirely overlapped with the second through hole TH2. The third through hole TH3 can be formed by using a mechanical device, such as a tip, or a laser device.

For instance, the window layer 400 can be patterned by a tip having a width of about 40µm to about 80µm. In addition, the third through hole TH3 can be formed by a laser beam having a wavelength of about 200nm to about 600nm.

In particular, the third through hole TH3 can be formed by removing only the transparent conductive material. In detail, the third through hole TH3 can be formed by removing the single-type material. Thus, the third through hole TH3 can be easily formed by the laser. That is, the single-type laser is used to form the third through hole TH3, so that the part of the window layer 400 can be effectively removed.

The third through hole TH3 has a width of about 50µm to about 100µm.

In this manner, only the single-type material is removed to divide the cells C1, C2... and Cn without patterning a plurality of layers.

Thus, according to the method of fabricating the solar cell apparatus of the embodiment, the laser patterning process can be effectively employed so that the solar cell apparatus can be easily fabricated.

In addition, according to the embodiment, since the second through hole TH2 is partially or entirely overlapped with the third through hole TH3, the solar cell apparatus having the high efficiency can be fabricated.

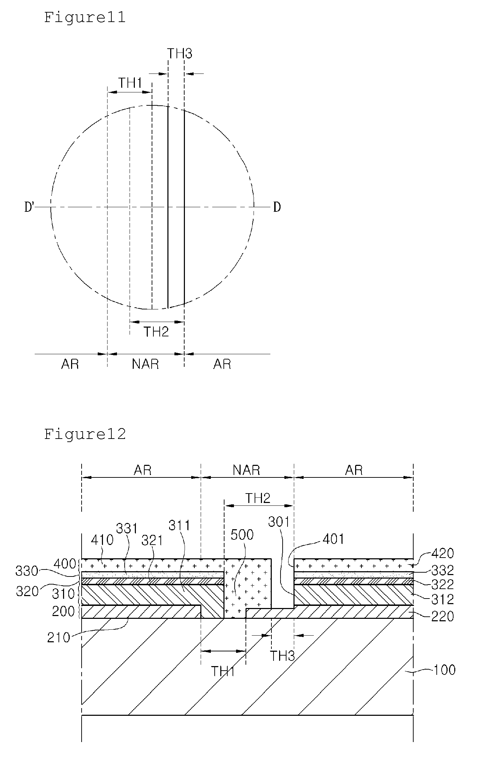

FIG. 10 is a plan view showing a solar cell apparatus according to another embodiment, FIG. 11 is an enlarged view of a "C" portion shown in FIG. 10, and FIG. 12 is a sectional view taken along line D-D'of FIG. 11. The solar cell apparatus according to another embodiment may be substantially identical to the solar cell apparatus according to the previous embodiment, except for several parts.

Referring to FIGS. 10 to 12, the solar cell apparatus according to another embodiment includes a support substrate 100, a back electrode layer 200, a light absorption layer 310, a buffer layer 320, a high-resistance buffer layer 330, a window layer 400 and a connection part 500.

The support substrate 100 has a plate shape to support the back electrode layer 200, the light absorption layer 310, the buffer layer 320, the high-resistance buffer layer 330, the window layer 400 and the connection part 500.

The support substrate 100 may include an insulating substance. The support substrate 100 may include a plastic substrate or a metal substrate. In detail, the support substrate 100 may include a soda lime glass substrate. The support substrate 100 may be transparent. The support substrate 100 may be rigid or flexible.

The back electrode layer 200 is aligned on the support substrate 100. The back electrode layer 200 is a conductive layer. For instance, the back electrode layer 200 may include a metal, such as molybdenum.

In addition, the back electrode layer 200 may include at least two layers, which are formed by using the same metal or different metals.

A first through hole TH1 is formed in the back electrode layer 200. The first through hole TH1 is an open region to expose the top surface of the support substrate 100. When viewed from the top, the first through hole TH1 may extend in one direction.

The first through hole TH1 may have a width of about 80µm to about 200µm.

The back electrode layer 200 is divided into a plurality of back electrodes 210, 220... and 200n by the first through hole TH1. That is, the back electrodes 210, 220... and 200n are defined by the first through hole TH1. Only the first and second back electrodes 210 and 220 are shown in FIG. 12.

The back electrodes 210, 220... and 200n are spaced apart from each other by the first through hole TH1. The back electrodes 210, 220... and 200n are arranged in a stripe pattern.

In contrast, the back electrodes 210, 220... and 200n can be arranged in the form of a matrix. In this case, the first through hole TH1 may have a lattice shape when viewed from the top.

The back electrodes 210, 220... and 200nmayhave step difference. In detail, the back electrodes 210, 220... and 200n are partially removed corresponding to the second through hole TH2 such that the step difference can be formed among them.

In other words, the thickness of the back electrode layer 200 may be variable according to the position thereof. For instance, the thickness of the back electrode layer 200 at the region corresponding to the second through hole TH2 may be thinner than the thickness of the back electrode layer 200 at the region besides the second through hole TH2.

The light absorption layer 310 is formed on the back electrode layer 200. In addition, the material included in the light absorption layer 310 is filled in the first through hole TH1.

The light absorption layer 310 may include I-III-VI group compound. For instance, the light absorption layer 310 may include the Cu-In-Ga-Se (Cu(In,Ga)Se₂; CIGS) crystal structure, the Cu-In-Se crystal structure or the Cu-Ga-Se crystal structure.

The light absorption layer 310 may have the energy bandgap of about lev to about 1.8eV.

The buffer layer 320 is formed on the light absorption layer 310. The buffer layer 320 includes CdS and has the energy bandgap of about 2.2eV to about 2.4eV.

The high-resistance buffer layer 330 is formed on the buffer layer 320. The high-resistance buffer layer 330 includes i-ZnO which is not doped with impurities. The high-resistance buffer layer 330 has the energy bandgap of about 3.1eV to about 3.3eV.

A second through hole TH2 is formed in the light absorption layer 310, the buffer layer 320 and the high-resistance buffer layer 330. That is, the second through hole TH2 is formed through the light absorption layer 310, the buffer layer 320 and the high-resistance buffer layer 330. The second through hole TH2 is an open region to expose the top surface of the back electrode layer 200.

The second through hole TH2 overlaps with the first through hole TH1. That is, the second through hole TH2 is partially overlapped with the first through hole TH1 when viewed from the top.

The second through hole TH2 may have a width of about 80µm to about 200µm.

The light absorption layer 310 is divided into a plurality of light absorption parts 311, 312... and 310n by the second through hole TH2. That is, the light absorption parts 311, 312... and 310n are defined by the second through hole TH2.

Similarly, the buffer layer 320 is divided into a plurality of buffers 321, 322... and 320n by the second through hole TH2 and the high-resistance buffer layer 330 is divided into a plurality of high-resistance buffers 331, 332... and 330n by the second through hole TH2.

The first light absorptionpart 311, the second light absorption part 312, the first buffer 321, the second buffer 322, the first high-resistance buffer 331 and the second high-resistance buffer 332 are shown in FIG. 12.

The window layer 400 is formed on the high-resistance buffer layer 330. The window layer 400 is a transparent conductive layer. In addition, the window layer 400 has resistance higher than that of the back electrode layer 200. For instance, the window layer 400 has resistance about 10 to 200 times higher than that of the back electrode layer 200. For instance, the window layer 400 may include Al-doped ZnO (AZO).

A third through hole TH3 is formed in the window layer 400. The third through hole TH3 is an open region to expose the top surface of the back electrode layer 200. The third through hole TH3 has a width smaller than a width of the second through hole TH2. For instance, the third through hole TH3 may have a width of about 40µm to about 100µm.

The third through hole TH3 is located corresponding to the second through hole TH2. In detail, the third through hole TH3 overlaps with the second through hole TH2. In other words, the third through hole TH3 may partially or entirely overlap with the second through hole TH2 when viewed from the top.

In addition, the third through hole TH3 may not overlap with the first through hole TH1.

Further, a part of an inner side of the third through hole TH3 is aligned on the same plane with a part of an inner side of the second through hole TH2. For instance, one inner side 401 of the third through hole TH3 matches with one inner side 301 of the second through hole TH2.

The window layer 400 is divided into a plurality of windows 410, 420... and 400n by the third through hole TH3. That is, the windows 410, 420... and 400n are defined by the third through hole TH3.

The windows 410, 420... and 400n have shapes corresponding to the shapes of the back electrodes 210, 220... and 200n. In detail, the windows 410, 420... and 400n are arranged in a stripe pattern. In contrast, the windows 410, 420... and 400n can be arranged in the form of a matrix.

A plurality of cells C1, C2...and Cn are defined by the third through hole TH3. In detail, the cells C1, C2...and Cn are defined by the second and third through holes TH2 and TH3. That is, the solar cell apparatus according to the embodiment is divided into the cells C1, C2...and Cn by the second and third through holes TH2 and TH3.

In other words, the solar cell apparatus according to the embodiment includes a plurality of cells C1, C2...and Cn. For instance, the solar cell apparatus according to the embodiment includes first and second cells C1 and C2 formed on the support substrate 100.

The first cell C1 may include the first back electrode 210, the first light absorption part 311, the first buffer 321, the first high-resistance buffer 331 and the first window 410.

The first back electrode 210 is disposed on the support substrate 100, and the first light absorption part 311, the first buffer 321, the first high-resistance buffer 331 and the first window 410 are sequentially stacked on the first back electrode 210.

In detail, the first back electrode 210 faces the first window 410 while interposing the first light absorption part 311 therebetween.

Although not shown in the drawings, the first light absorption part 311 and the first window 410 may cover the first back electrode 210 such that the top surface of the first back electrode 210 can be partially exposed.

The second cell C2 is disposed on the support substrate 100 in adjacent to the first cell C1. The second cell C2 may include the second back electrode 220, the second light absorption part 312, the second buffer 322, the second high-resistance buffer 332 and the second window 420.

The second back electrode 220 is disposed on the support substrate 100 while being spaced apart from the first back electrode 210. The second light absorption part 312 is disposed on the second back electrode 220 while being spaced apart from the first light absorption part 311. The second window 420 is disposed on the second high-resistance buffer 332 while being spaced apart from the first window 410.

The second light absorption part 312 and the second window 420 may cover the second back electrode 220 such that the top surface of the second back electrode 210 can be partially exposed.

The connection part 500 is positioned in the first and second through holes TH1 and TH2. In detail, a part of the connection part 500 is positioned in the first through hole TH1. That is, the part of the connection part 500 is disposed between the first and second back electrodes 210 and 220.

The connection part 500 extends downward from the window layer 400 and directly makes contact with the back electrode layer 200. For instance, the connection part 500 extends downward from the first window 410 and directly makes contact with the second back electrode 220.

Thus, the connection part 500 connects the window with the back electrode included in adjacent cells, respectively. In detail, the connection part 500 connects the first window 410 with the second back electrode 220.

The connection part 500 is integrally formed with the windows 410, 420... and 400n. That is, the connection part 500 is formed by using a material the same as that of the window layer 400.

The connection part 500 makes contact with one side of the second through hole TH2 and is spaced apart from the other side 301 of the second through hole TH2. For instance, the connection part 500 makes contact with a lateral side of a light absorption part included in the first cell C1 and is spaced apart from a lateral side of a light absorption part included in the second cell C2.

In addition, the connection part 500 makes contact with the lateral sides and top surfaces of the back electrodes 210, 220... and 200n. For instance, as shown in FIG. 12, the connection part 500 makes contact with the lateral side and the top surface of the first back electrode 210. That is, the connection part 500 makes contact with one inner side of the first through hole TH1.

The first to third through holes TH1 to TH3 are dead zones where the light may not be converted into the electric energy. That is, the first to third through holes TH1 to TH3 are non-active regions (NAR).

Since the second through hole TH2 partially overlaps with the first through hole TH1, and the third through hole TH3 overlaps with the second through hole TH2, the area of the non-active regions can be reduced.

Thus, the solar cell apparatus according to the embodiment can increase the area of the active region where the light is converted into the electric energy, so that the efficiency of the solar cell apparatus can be improved.

In addition, since the connection part 500 makes contact with the lateral sides and top surfaces of the back electrodes 210, 220... and 200n, the solar cell apparatus according to the embodiment may have the superior connection characteristic as compared with that of the solar cell apparatus having the connection part that only makes contact with the top surfaces of the back electrodes.

Accordingly, the solar cell apparatus according to the embodiment can prevent the short between the connection part 500 and the back electrodes 210, 220... and 200n, while lowering the contact resistance.

Therefore, the solar cell apparatus according to the embodiment may have the improved efficiency and low defective rate.

In addition, since the first through hole TH1 overlaps with the second through hole TH2, the width of the first through hole TH1 and the distance between two adjacent back electrodes 210 and 220 can be increased.

Thus, the solar cell apparatus according to the embodiment can prevent the short between the connectionpart 500 and the back electrodes 210, 220... and 200n.

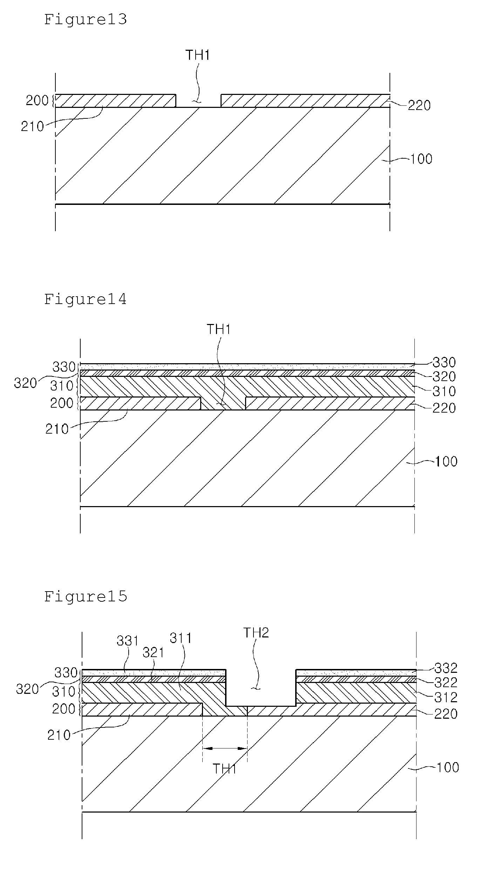

FIGS. 13 to 18 are sectional views showing the method of fabricating the solar cell apparatus according to another embodiment. The following description will be made with reference to the description about the solar cell apparatus according to another embodiment.

Referring to FIG. 13, the back electrode layer 200 is formed on the support substrate 100 and is patterned to form the first through hole TH1. Thus, a plurality of back electrodes 210, 220...and 200n are formed on the support substrate 100. A laser is used to pattern the back electrode layer 200.

The first through hole TH1 exposes the top surface of the support substrate 100 and has a width of about 80µm to about 200µm.

In addition, an additional layer, such as a diffusion barrier, can be interposed between the support substrate 100 and the back electrode layer 200. In this case, the first through hole TH1 exposes the top surface of the additional layer.

Referring to FIG. 14, the light absorption layer 310, the buffer layer 320 and the high-resistance buffer layer 330 are sequentially formed on the back electrode layer 200.

The light absorption layer 310 can be formed through the sputtering process or the evaporation process.

For instance, Cu, In, Ga and Se are simultaneously or individually evaporated to form the CIGS (Cu(In,Ga)Se₂) light absorption layer 310, or the selenization process is performed after forming a metal precursor layer in order to form the light absorption layer 310.

According to the selenizationprocess, the metal precursor layer is formed on the back electrode layer 200 by performing the sputtering process using a Cu target, an In target and a Ga target.

Then, the metal precursor layer is processed through the selenization process, thereby forming the CIGS light absorption layer 310.

In addition, the sputtering process using the Cu target, the In target and the Ga target and the selenization process can be simultaneously performed.

Further, the CIS light absorption layer 310 or the CIG light absorption layer 310 can be formed by performing the sputtering process using the Cu target and the In target or the Cu target and the Ga target and the selenization process.

Then, CdS is deposited on the light absorption layer 310 through the sputtering process, so that the buffer layer 320 is formed.

After that, ZnO is deposited on the buffer layer 320 through the sputtering process, so that the high-resistance buffer layer 330 is formed.

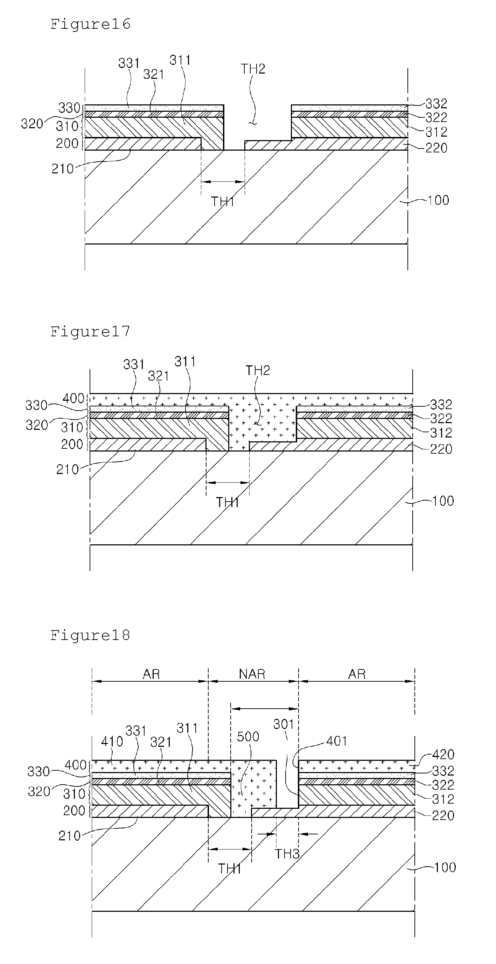

Referring to FIGS. 15 and 16, the light absorption layer 310, the buffer layer 320 and the high-resistance buffer layer 330 are partially removed to form the second through hole TH2. The second through hole TH2 is formed through the light absorption layer 310, the buffer layer 320 and the high-resistance buffer layer 330.

The second through hole TH2 overlaps with the first through hole TH1. The second through hole TH2 can be formed by using a mechanical device, such as a tip, or a laser device.

For instance, the light absorption layer 310, the buffer layer 320 and the high-resistance buffer layer 330 can be patterned by a tip having a width of about 40µm to about 180µm. In addition, the second through hole TH2 can be formed by a laser beam having a wavelength of about 200nm to about 600nm.

At this time, the second through hole TH2 may have a width of about 100µm to about 200µm. In addition, the second through hole TH2 may expose a part of the top surface of the back electrode layer 200. The second through hole TH2 can be formed by performing the patterning process two times as follows.

First, the light absorption layer 310, the buffer layer 320 and the high-resistance buffer layer 330 are partially removed such that the I-III-VI group compound may remain in the first through hole TH1. Then, the I-III-VI group compound filled in the first through hole TH1 is removed. The above processes can be performed by using the mechanical device or the laser device.

At this time, a part of the back electrode layer 200 is removed so that the step difference occurs among the back electrodes 210, 220... and 200n.

In addition, when the light absorption layer 310, the buffer layer 320 and the high-resistance buffer layer 330 are scribed by the mechanical device, fine concavo-convex patterns may be formed on the back electrodes 210, 220... and 200n. In detail, the fine concavo-convex patterns are formed as the back electrodes 210, 220... and 200n are partially removed by the tip.

In contrast, the second through hole TH2 can be formed through one process. That is, the I-III-VI group compound filled in the first through hole TH1 can be removed through one scribing process or one laser irradiation process.

While the second through hole TH2 is being formed through one process, the back electrode layer 200 is partially removed. That is, the step difference occurs among the back electrodes 210, 220... and 200n. In addition, fine concavo-convex patterns may be formed on the back electrodes 210, 220... and 200n.

Referring to FIG. 17, the window layer 400 is formed on the high-resistance buffer layer 330. At this time, the material to form the window layer 400 is filled in the first and second through holes TH1 and TH2.

In order to form the window layer 400, a transparent conductive material is deposited on the high-resistance buffer layer 330. The second through hole TH2 is fully filled with the transparent conductive material. For instance, the transparent conductive material includes Al-doped ZnO.

Referring to FIG. 18, the window layer 400 is partially removed to form the third through hole TH3. That is, the window layer 400 is patterned to define the windows 410, 420... and 400n and cells C1, C2...and Cn.

While the third through hole TH3 is being formed, the transparent conductive material filled in the second through hole TH2 is partially removed. Thus, the top surface of the back electrode layer 200 is exposed through the third through hole TH3.

In addition, the connection part 500, which extends from the window layer 400 and directly makes contact with the back electrode layer 200, is formed in the first and second through holes TH1 and TH2. Thus, the connection part 500 makes contact with one inner side of the first through hole TH1. That is, the connection part 500 makes contact with the lateral sides and top surfaces of the windows 410, 420... and 400n.

One inner side of the third through hole TH3 matches with one inner side of the second through hole TH2.

For instance, the window layer 400 and the transparent conductive material filled in the second through hole TH2 may be partially removed in such a manner that one inner side of the third through hole TH3 matches with one inner side of the second through hole TH2.

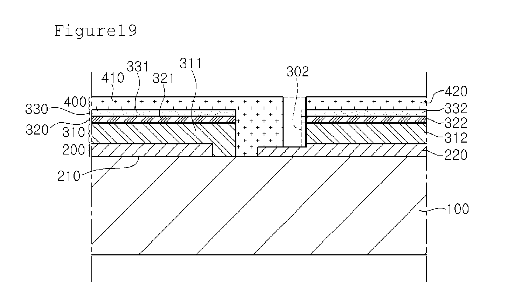

In contrast, as shown in FIG. 19, a part of the window layer 400, the light absorption layer 310, the buffer layer 320 and a part 302 of the high-resistance buffer layer 330 can be removed while the third through hole TH3 is being formed.

The third through hole TH3 is partially or entirely overlapped with the second through hole TH2. The third through hole TH3 can be formed by using a mechanical device, such as a tip, or a laser device.

For instance, the light absorption layer 310 can be patterned by a tip having a width of about 30µm to about 80µm. In addition, the third through hole TH3 can be formed by a laser beam having a wavelength of about 200nm to about 600nm.

In particular, the third through hole TH3 can be formed by removing only the transparent conductive material. In detail, the third through hole TH3 can be formed by removing the single-type material. Thus, the third through hole TH3 can be easily formed by the laser. That is, the single-type laser is used to form the third through hole TH3, so that the part of the window layer 400 can be effectively removed.

The third through hole TH3 has a width of about 40µm to about 100µm.

In this manner, only the single-type material is removed to divide the cells C1, C2... and Cn without patterning a plurality of layers.

Thus, according to the method of fabricating the solar cell apparatus of the embodiment, the laser patterning process can be effectively employed so that the solar cell apparatus can be easily fabricated.

In addition, according to the embodiment, since the second through hole TH2 is partially or entirely overlapped with the third through hole TH3, the solar cell apparatus having the high efficiency can be fabricated.

In addition, the contact characteristic between the back electrodes 210, 220... and 200n and the windows 410, 420... and 400n can be improved due to the fine concavo-convex patterns formed on the back electrodes 210, 220... and 200n. Therefore, the contact resistance between the back electrodes 210, 220... and 200n and the connection part 500 can be reduced and the solar cell apparatus according to the embodiment can prevent the short among the cells C1, C2... and Cn.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell apparatus comprising:
a substrate;
an electrode layer having a first through hole on the substrate;
a light absorption layer having a second through hole on the electrode layer; and
a window layer having a third through hole overlapped with the second through hole on the light absorption layer.

2. The solar cell apparatus of claim 1, wherein one inner side of the second through hole is aligned on a same plane with one inner side of the third through hole.

3. The solar cell apparatus of claim 1, wherein the third through hole entirely overlaps with the second through hole.

4. The solar cell apparatus of claim 1, wherein the second through hole has a width larger than a width of the third through hole.

5. The solar cell apparatus of claim 1, further comprising a connection part disposed in the second through hole and extending from the window layer so as to be connected to the electrode layer, wherein the connection part directly makes contact with one inner side of the second through hole and is spaced apart from the other inner side of the second through hole.

6. The solar cell apparatus of claim 1, wherein the first through hole overlaps with the second through hole.

7. The solar cell apparatus of claim 6, further comprising a connection part extending from the window layer and disposed in the first and second through holes.

8. The solar cell apparatus of claim 6, wherein a thickness of the electrode layer at a region corresponding to the second through hole is thinner than a thickness of the electrode layer at a region besides the second through hole.

9. The solar cell apparatus of claim 1, wherein the first through hole is adjacent to the second through hole.

10. The solar cell apparatus of claim 1, wherein the first through hole overlaps with the second through hole.

11. A solar cell apparatus comprising:
a substrate;
first and second back electrodes spaced apart from each other on the substrate;
a first light absorption part on the first back electrode;
a first window on the first light absorption part;
a second light absorption part on the second back electrode;
a second window on the second light absorption part; and
a connection part extending from the first window and making contact with one lateral side of the first light absorption part while being spaced apart from the second light absorption part so as to be connected to the second back electrode,
wherein the connection part makes contact with a lateral side and a top surface of the second back electrode.

12. The solar cell apparatus of claim 11, wherein the second back electrode has a step difference.

13. A method of fabricating a solar cell apparatus, the method comprising:
forming an electrode layer on a substrate;
forming a first through hole by partially removing the electrode layer;
forming a light absorption layer on the electrode layer;
forming a second through hole adjacent to the first through hole by partially removing the light absorption layer;
forming a window layer on the light absorption layer; and
forming a third through hole overlapped with the second through hole by partially removing the window layer.

14. The method of claim 13, wherein a conductive material is filled in the second through hole when the window layer is formed, and the conductive material is partially removed when the third through hole is formed.

15. The method of claim 13, wherein the light absorption layer is partially removed when the third through hole is formed.

16. The method of claim 13, wherein the second through hole partially overlaps with the first through hole.

17. The method of claim 16, wherein a semiconductor material is filled in the first through hole when the light absorption layer is formed, and the semiconductor material filled in the first through hole is partially removed when the second through hole is formed.

18. The method of claim 17, wherein the forming of the second through hole includes partially removing the light absorption layer and partially removing the semiconductor material filled in the first through hole.

19. The method of claim 16, wherein the electrode layer is partially removed when the second through hole is formed so that a step difference is formed in the electrode layer.
